# EUROPEAN PATENT APPLICATION

(11) **EP 2 908 145 A1**
(43) Date of publication of application: **19.08.2015**
(21) Application number: 12886207.5
(22) Date of filing: 11.10.2012
(51) Int. Cl.: G01R 31/02, G01R 31/00

(54) **METHOD FOR TESTING CABLE CORE FOR SUPERCONDUCTING CABLE, AND COOLING CONTAINER**

(71) Applicant: Sumitomo Electric Industries, Ltd., Osaka-shi, Osaka 541-0041 (JP)
(72) Inventor: TATAMIDANI, Kazuaki, Osaka-shi, Osaka 554-0024 (JP); SETOGUCHI, Tadashi, Osaka-shi, Osaka 554-0024 (JP); OHYA, Masayoshi, Osaka-shi, Osaka 554-0024 (JP)
(74) Representative: Delumeau, François Guy
(86) International application number: PCT/JP2012/076366
(87) International publication number: WO 2014/057565

(57) **Abstract**

Provided are a test method for testing a cable core for a superconducting cable and a cryostat used for the test method, whereby electrical characteristics can be tested over the entire length of a cable core of a superconducting cable. A cable core (100) provided with a superconducting conductor layer (102) is accommodated in a cryostat (1) having a vacuum insulation layer (2a) on at least a portion thereof. The cryostat (1) is filled with a liquid coolant (2L). A cooling gas is introduced into a gas phase (2A) in the cryostat (1), the gas phase (2A) is placed in a pressurized state at a pressure greater than atmospheric pressure, the superconducting conductor layer (102) is electrified or charged while the superconducting conductor layer (102) is maintained in a superconducting state by the liquid coolant (2L), and electrical characteristics over the entire length of the cable core (100) are measured. During this measurement, the pressure of the gas phase (2A) in the cryostat (1) and the temperature of the liquid coolant (2L) are measured without circulative cooling of the liquid coolant (2L) in the cryostat (1), and the liquid coolant (2L) is monitored on the basis of the measurement results as to whether the state thereof is suitable for continuation of testing.

## Description

### Technical Field

The present invention relates to a test method for testing a cable core of a superconducting cable and a cryostat used for the test method. The method enables to test electrical characteristics of a cable core which is the main component of a superconducting cable over the entire length.

### Background

Superconducting cables have been developed as power cables that constitute power supply lines. The superconducting cables are typically provided with a cable core having a superconducting layer and a thermal insulation pipe filled with a coolant such as, for example, liquid nitrogen, to store the cable core.

When examining the electrical characteristics, the superconducting cable needs to be cooled in order to place the superconducting layer in a superconducting state. Thus, when performing a test on the superconducting cable over the entire length, it is necessary to fill a thin thermal insulation pipe with a coolant, which requires a substantial time. Thus, Patent Document 1 proposes performing a full-length test on the superconducting cable under a room temperature by filling the thermal insulation pipe with a gas, instead of the coolant.

### [Prior Art Document]

### [Patent Document]

Patent Document 1: Japanese Patent No. 4683371

### Summary of the Invention

### Problems to be Solved

Recently, it has been requested that a full-length test be performed on a cable core that is used for a superconducting cable rather than on a superconducting cable itself.

The full-length test proposed in Patent Document 1 is targeted for a superconducting cable with a cable core stored in a thermal insulation pipe. The electrical characteristics of the superconducting cable are substantially the same as those of the cable core. Thus, when the electric characteristics of the cable core itself are not satisfying before the cable core is stored in the thermal insulation pipe, it is natural that the results of a full-length test of the superconducting cable using the cable core are not satisfying as well. In addition, when a cable core is shipped as a single body, the testing object in a shipping test is the cable core itself. Accordingly, it is requested that the full-length test on the cable core be performed before the cable core is stored in the thermal insulation pipe. However, a test method suitable for a cable core for a superconducting cable has not yet been proposed.

The present invention has been made taking the above-mentioned circumstances into consideration, and one of the objects of the present invention is to provide a test method for testing a cable core for a superconducting cable and a cryostat used for the test method. The method enables to test electrical characteristics of a cable core which is the main component of a superconducting cable over the entire length.

### Means to Solve the Problems

When performing a test on a cable core for a superconducting cable over the entire length, the electrical characteristics of the cable core may be tested in a state where the cable core is stored in a proper cryostat and a coolant is circulated within the cryostat. However, the test requires a circulation cooling system including a mechanism that circulates the coolant within the cryostat and a mechanism that cools the circulated coolant. Thus, the test facility should be formed in a large scale and thus a wide space is required for the test. Going one step further, the inventors of the present invention have considered the subject matter on how to perform the full-length test on the cable core with a simple configuration without using the circulation cooling system, and have completed the present invention.

A method for testing a cable core for a superconducting cable according to the present invention includes the following steps.
[Storing step] ... a cable core with a superconducting layer is stored in a cryostat including a vacuum thermal insulation layer provided on at least a part of the cryostat.
[Filling step] ... the cryostat is filled with a liquid coolant.
[Measuring step] ... a cooling gas is introduced into a gas phase within the cryostat so as to place the gas phase in a pressurized state at a pressure higher than atmospheric pressure, the superconducting layer is electrified or charged while the superconducting layer is maintained at a superconducting state by the liquid coolant, and electrical characteristics are measured over the entire length of the cable core.

Here, in the measuring step, the pressure of the gas phase and the temperature of the liquid coolant within the cryostat are measured without circulative cooling of the liquid coolant, and the electrical characteristics are measured while monitoring whether the liquid coolant is in a state suitable for continuing the testing based on the measured results.

The saturated vapor pressure curve of the liquid coolant (the horizontal and vertical axes represent temperature and pressure, respectively) typically has a positive slope with respect to a temperature. When the pressure of the gas phase within the cryostat increases as in the method for testing a cable core for a superconducting cable according to the present invention, the boiling point of the liquid coolant increases and thus, the vaporization of the liquid coolant is suppressed. Thus, the testing time can be considerably extended compared to a case where the gas phase is not compressed. That is, according to the method of testing a cable core for a superconducting cable according to the present invention, the full-length test of the cable can be performed over a considerably long period of time without always continuously performing the circulative cooling of the liquid coolant with the circulation cooling system provided with the cryogenic refrigerator. In addition, in the measuring step of the method for testing a cable core for a superconducting cable according to the present invention, it is allowed to reduce the temperature of the liquid coolant within the cryostat and to further extend the testing time by replenishing the cryostat with the liquid coolant. Since merely replenishing the cryostat with the liquid coolant only requires providing a simple coolant tank in the vicinity of the cryostat, the test facility would never be excessively enlarged.

In addition, according to the method for testing a cable core for a superconducting cable according to the present invention, the pressure of the gas phase and the temperature of the liquid coolant are always monitored during the measuring step. Thus, the testing under an improper condition can be avoided and as a result, highly reliable testing results can be obtained.

In an embodiment of the method for testing a cable core for a superconducting cable according to the present invention, the introduction amount of the cooling gas may be adjusted based on the measured temperature data of the liquid coolant and the measured pressure data of the gas phase.

The introduction of the cooling gas for placing the gas phase in the pressurized state may be performed according to a predetermined schedule, but the introduction amount may be properly adjusted according to a situation. At that time, the pressure of the gas phase may be adjusted by referring to the temperature data and the pressure data so that the boiling of the liquid coolant may be efficiently suppressed. As a result, the available testing time can be maintained longer compared to a case where the cooling gas is introduced according to the predetermined schedule.

Here, in the method for testing a cable core for a superconducting cable according to the present invention, the liquid coolant filled in the cryostat is not cooled again. Thus, it is important to determine how long the full-length test can be performed. At that time, when the temperature data and the pressure data are monitored over time, estimation may be made as to how long the full-length test can be continued from the present time (the time limit of the test).

According to an aspect of the method for testing a cable core for a superconducting cable of the present invention, the data regarding heat penetration into the cryostat may also be considered, in addition to the temperature data and the pressure data, when adjusting the introduction amount of the cooling gas.

When the heat penetration data such as, for example, the amount and rate of the heat penetration into the cryostat can be determined, the trends on the temperature rise of the liquid coolant can be estimated with a considerable preciseness. Thus, when the introduction amount of the cooling gas is adjusted considering the heat penetration data in addition to the temperature data and the pressure data, the available testing time can be maintained longer. In addition, when estimating the time limit of the test, more correct estimates can be made by considering the heat penetration data. Here, for example, the amount of the liquid coolant vaporized by the heat penetration may be used as a factor for determining the heat penetration. That is, a change in the height of the liquid-level of the liquid coolant from the start of the test to the present time may be used as a factor for determining the heat penetration. The height of the liquid-level may be determined using a proper liquid-level measurement means.

According to an aspect of the method for testing a cable core for a superconducting cable of the present invention, the liquid coolant within the cryostat may be stirred. For stirring the liquid coolant, a stirring means such as, for example, a fin provided within the cryostat, may be used.

When the liquid coolant is stirred, an occurrence of a local temperature rise in the liquid coolant can be suppressed. Then, the reliability of test results can be enhanced since the cable core can be suppressed from being in a state where some portions of the cable core are in a condition suitable for test while other portions are not in the condition suitable for test.

According to an aspect of the method for testing a cable core for superconducting cable of the present invention, a cryostat used for testing may include: a main body part having a bottomed cylindrical shape with an opening at one end side and including a vacuum thermal insulation layer formed according to the shape; and a cover part configured to cover the opening. The cover part is not provided with the vacuum thermal insulation layer. In such a case, a communicating tube of a pressure measurement means that measures the pressure of the gas phase, a signal line of the temperature measurement means that measures the temperature of the liquid coolant, and a gas pipe of a gas phase pressurizing means that introduces a coolant gas into the gas phase may be provided to penetrate the cover part of the cryostat.

When the vacuum thermal insulation layer is formed on the main body part according to the shape of the main body part, the heat penetration into the cryostat can be efficiently suppressed. Meanwhile, since the vacuum thermal insulation layer is not formed on the cover part, it is easy to mount various means on the cryostat. The various means certainly have a portion that penetrates inside and outside the cryostat. Specifically, the pressure measurement means includes, for example, a communicating tube that guides the gas of the gas phase within the cryostat to a pressure gauge disposed outside the cryostat, and the temperature measurement means includes, for example, a signal line that transmits temperature data from a resistance thermometer immersed in the liquid coolant in the cryostat to the outside of the cryostat. In addition, the gas phase pressurizing means includes, for example, a gas pipe that introduces a cooling gas from the outside of the cryostat into the gas phase in the cryostat. When no vacuum thermal insulation layer exists on the cover part, it is easy to allow the communicating tube, the signal line, and the gas pipe to penetrate the cover part.

In an embodiment of the method for testing a cable core for a superconducting cable of the present invention, a thermal insulator may be stacked on at least one surface of the cover part.

With this configuration, heat penetration through the cover part can be reduced. For example, a foamed resin such as, for example, urethane, may suitably be used as the thermal insulator.

According to an aspect of the method for testing a cable core for a superconducting cable of the present invention, in the measuring step, the cover part may be cooled by a fluid type coolant. For example, a coolant channel may be formed within the cover part. In such a case, the coolant channel is formed so as to avoid the area where various means penetrates the cover part. Further, a configuration may be adopted in which a pipe serving as the coolant channel is aligned on at least one side of the cover part. Here, the coolant used for cooling the cover part may be provided independently from the liquid coolant for cooling the cable core.

With this configuration, the heat penetration through the cover part can be reduced. Needless to say, the configuration in which cooling is performed by the fluid type coolant may be combined with the configuration in which the thermal insulator is used.

According to an aspect of the method for testing a cable core for a superconducting cable of the present invention, in the storing step, the cable core may be stored in the cryostat in a state where the cable core is wound around a drum.

By winding the long cable core around the drum, the cable core may be compactly arranged to be easily treated. When the cable core is compactly arranged, the cryostat that stores the cable core can also be made compact, and thus, the test space can be made small.

According to an aspect of the method for testing a cable core of a superconducting cable using the cryostat provided with the cover part of the present invention, in the storing step, the cable core may be stored in the cryostat in a state where the cable core is wound around the drum and suspended from the cover part together with the drum.

Since the cable core may be stored in the cryostat simultaneously with the sealing of the cryostat by the cover part in the state where the drum is suspended from the cover part of the cryostat, the test workability of the cable core is excellent.

According to an aspect of the method of testing a cable core for a superconducting cable of the present invention where the drum is suspended from the cover part of the cryostat, the drum suspended from the cover part may not be in contact with the bottom of the cryostat.

Since the drum is not to be in contact with the bottom of the cryostat, the entire circumference of the drum can be surrounded by the coolant so that the drum and the cable core wound around the drum can be uniformly cooled.

According to an aspect of the method for testing a cable core of a superconducting cable of the present invention in which testing is performed in a state where the cable core is wound around the drum, in the storing step, the superconducting cable core may be in the cryostat such that the axis of the drum is parallel to the axis of the cryostat in the depth direction.

When the cable core is stored such that the axis of the drum is parallel to the axis of the cryostat in the depth direction (hereinafter, this storage type may be referred to as "vertical-type storage"), the cryostat may have a bottom size according to the diameter of the flange portion, even in a case where the winding drum is lengthened to wind the cable core having a considerably long length. Thus, the size of the cryostat may be minimized compared to a case where the cable core is stored in the cryostat such that the axis of the drum is orthogonal to the axis of the cryostat in the depth direction (hereinafter, this storage type may be referred to as "horizontal-type storage"). In addition, when the drum is stored in the cryostat in the vertical-type storage, the non-uniformity of the tension acting on the cable core can be reduced compared to the horizontal-type storage.

According to an aspect of the method for testing a cable core for a superconducting cable of the present invention in which the test is performed in a state where the cable core is wound around the drum, the drum may include a winding drum around which the cable core is wound, and flange portions which are respectively provided on both ends of the winding drum. At least one flange portion may be attachable/detachable with respect to the winding drum. In such a case, in the storing step, the cable core is stored in the cryostat in a state where the one flange portion is removed.

With this configuration, since the one flange portion is removed when the drum is stored in the cryostat, the ends of the cable core may be easily drawn out and the lead electrodes for electrification or charging may be easily mounted on the ends. In addition, when the weight of the drum is reduced by removing the one flange portion, the storing step can be facilitated. In particular, when the weight of the drum is reduced even just a little, it is a great advantage in the case where the drum is suspended from the cover part of the cryostat.

A cryostat of the present invention includes a vacuum thermal insulation layer on at least a portion thereof so as to maintain a liquid coolant therein. The cryostat may include a temperature measurement means, a pressure measurement means, and a gas phase pressurizing means. When electrical characteristics are measured over an entire length of a cable core provided with a superconducting layer, the cryostat is used in a state where the core cable and the liquid coolant are stored therein. Here, the temperature measurement means is configured to measure a temperature of the liquid coolant within the cryostat, the pressure measurement means is configured to measure a pressure of a gas phase within the cryostat, and the gas phase pressuring means is configured to introduce a cooling gas into the gas phase.

The cryostat of the present invention is suitable for use in the method for testing a cable core for a superconducting cable of the present invention.

According to an aspect of the present invention, the cryostat may include, for example, a main body part having a bottomed cylindrical shape with an opening at one end side and including a vacuum thermal insulation layer formed according to the shape of the main body part; and a cover part having no vacuum thermal insulation part and configured to cover the opening. A signal line of the temperature measurement means, a communicating tube of the pressure measurement means, and a gas pipe of the gas phase pressurizing means may penetrate the cover part.

When the vacuum thermal insulation layer is formed on the main body part according to the shape of the main body part, the heat penetration into the cryostat can be efficiently suppressed. Meanwhile, since the vacuum thermal insulation layer is not formed on the cover part, it is easy to mount various means on the cryostat.

According to an aspect of the present invention, the cryostat may include a liquid-level measurement means that measures the height of the liquid-level of the liquid coolant.

When the liquid-level measurement means is provided, the evaporation amount of the liquid coolant can be monitored. When the evaporation amount is monitored, the amount and rate of the heat penetration can be determined. The heat penetration data may be used for controlling the gas phase pressurizing means, for example.

According to an aspect of the present invention, the cryostat may include a stirring means that stirs the liquid coolant.

When the stirring means is provided, an occurrence of local temperature rise in the liquid coolant within the cryostat can be suppressed.

### Effect of the Invention

The method for testing a cable core for a superconducting cable according to the present invention can precisely examine electrical characteristics over the entire length of the cable core with a simple configuration.

### Brief Description of Drawings

FIG. 1 is an explanatory view for describing a method for testing a cable core for a superconducting cable according to an embodiment.
FIG. 2 is an explanatory view for describing a sequence of storing a cable core in a cryostat, in which FIG. 2(A) illustrates a state where the cable core is wound around a drum, FIG. 2(B) illustrates a state where a flange portion of one end side of the drum is removed, and FIG. 2(C) illustrates a state where the cable core is stored in a main body part of the cryostat.
FIG. 3 is a cross-sectional view schematically illustrating a cable core for a superconducting cable.

### Detailed Description to Execute the Invention

Hereinafter, the present invention will be described in more detail with reference to the accompanying drawings. In the drawings, the same components will be denoted by the same symbols. A cable core for a superconducting cable which is a testing object, a drum around which the cable core is wound, and a cryostat that stores the testing object will be described first, and a method for testing the cable core will be described thereafter.

### [Cable Core]

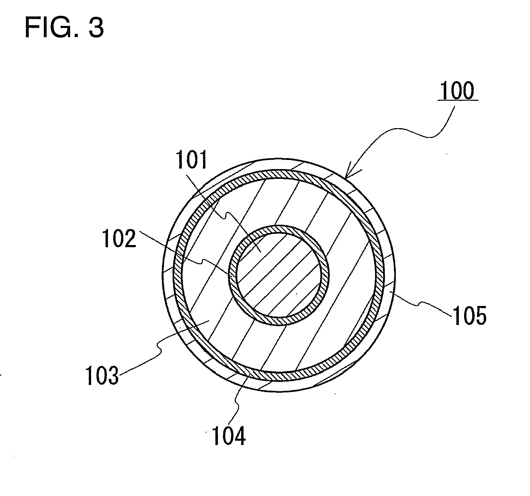

A cable core will be described with reference to FIG. 3. The cable core 100 includes, for example, a former 101, a superconducting layer 102, an electrical insulating layer 103, an outer superconducting layer 104, and a protective layer 105 in this order from the center.

The former 101 is a support member for the superconducting layer 102 and also serves as a tensile strength material for the cable core 100. In addition, the former 101 may be used as a current shunt at an abnormal time. When used as the shunt, the former 101 may be formed as a solid body or a hollow body made of a normal conducting material such as, for example, copper, aluminum or an alloy thereof. For example, the solid body may be formed using stranded wires made by twisting a plurality of copper wires provided with an electrical insulating coating of, for example, polyvinyl formal (PVF) or enamel. A cushion layer formed by winding an electrically insulating tape such as, for example, a craft paper or a polypropylene laminated paper (PPLP: registered trademark of Sumitomo Electric Industries, Ltd), may be provided on the outer periphery of the former 101.

The superconducting layer 102 and the outer superconducting layer 104 may be formed, for example, by spirally winding a superconducting wire in a single layer or multilayers. The superconducting wire may be a wire including an oxide superconducting phase, specifically, a thin film wire including a rare-earth-based oxide superconducting phase including REBa₂Cu₃Oₓ (RE 123) (RE is a rare earth element), for example, YBCO, HoBCO or GdBCO, or a high temperature superconducting wire including a bismuth-based oxide superconducting phase such as, for example, Bi₂Sr ₂Ca₂Cu₃O_{10+δ} (Bi2223) in which Ag or an alloy thereof serves as a metal matrix. In the case of the multiple layer structure, an inter-layer insulating layer may be formed between wire layers by winding an electrical insulating paper such as, for example, a craft paper. In addition, an inner semi-conductive layer may be provided just above the superconducting layer 102 by winding, for example, a carbon paper.

The outer superconducting layer 104, for example, may be used as a magnetic shield in a case of alternating-current power transmission, or as a return conductor or a neutral line in a case of direct-current power transmission. The number of superconducting wires or wire layers that constitute the superconducting layer 102 and the outer superconducting layer 104 is determined according to a desired supply capacity of electric power.

The electrical insulating layer 103 may be formed on the superconducting layer 102 (or the inner semi-conductive layer) by winding an electrically insulating tape material such as, for example, a craft paper or a semi-synthesized electrical-insulating paper such as, for example, PPLP (registered trademark). In addition, an outer semi-conductive layer may be formed just above the electrical insulating layer 103 by winding, for example, a carbon paper.

The protective layer 105 may be formed on the outer periphery of the outer superconducting layer 104 (or a normal conducting shield provided on the outer periphery of the outer superconducting layer 104) by winding an electrical insulating tape material such as, for example, a craft paper or a semi-synthesized electrical-insulating paper such as, for example, PPLP (registered trademark). The protective layer 105 serves to mechanically protect the outer superconducting layer 104.

The cable core 100 described above is used as a component of the superconducting cable. The superconducting cable is manufactured by introducing a single cable core 100 or multiple (typically three) cable cores 100 into a single thermal insulation pipe (not illustrated). The thermal insulation pipe is typically a vacuum thermal insulation structure which is formed of double pipes of an inner pipe and an outer pipe with a vacuum state being formed between the inner pipe and the outer pipe. The superconducting cable is used for a power supply line in a state where the thermal insulation pipe is filled with a coolant (*e.g*., a liquid coolant such as, for example, liquid nitrogen or liquid helium) and the superconducting layer 102 and the outer superconducting layer 104 are cooled by the coolant so as to be in a superconducting state.

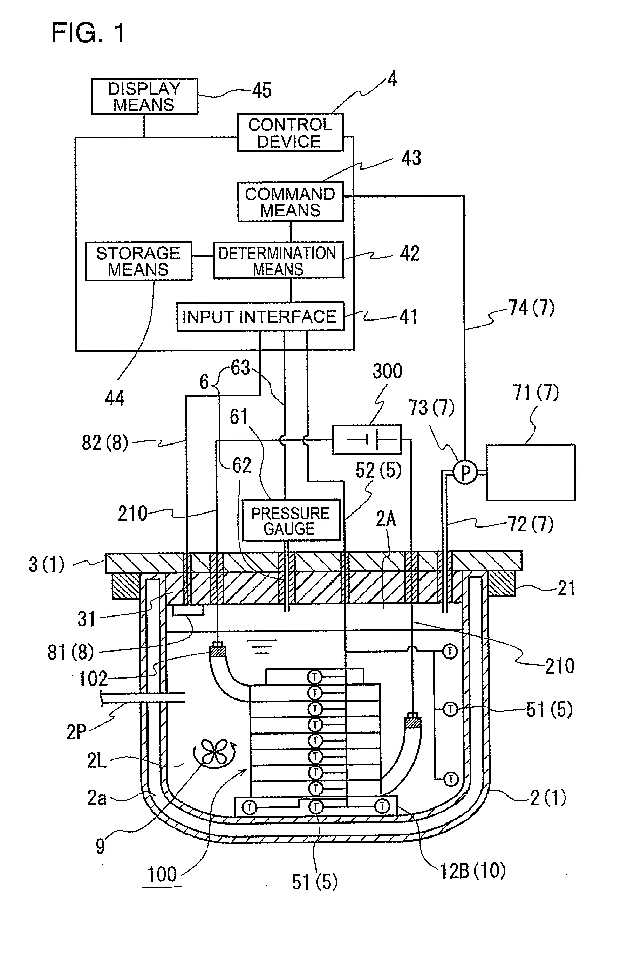

In a full-length test, as illustrated in FIG. 1, lead electrodes 210 are mounted on the superconducting layer 102 at each end of the cable core 100 (although not illustrated, the lead electrodes 210 are also mounted on the outer superconducting layer 104). The lead electrodes 210 are connected to the superconducting layer 102 with proper connection members (not illustrated). The lead electrodes 210 and the connection members may be formed in a proper shape and length using a proper conductive material such as, for example, copper or a copper alloy, to be capable of being electrified or charged. For example, an electrical insulating tape may be wound around the lead electrodes 210 and the connection members.

### [Drum]

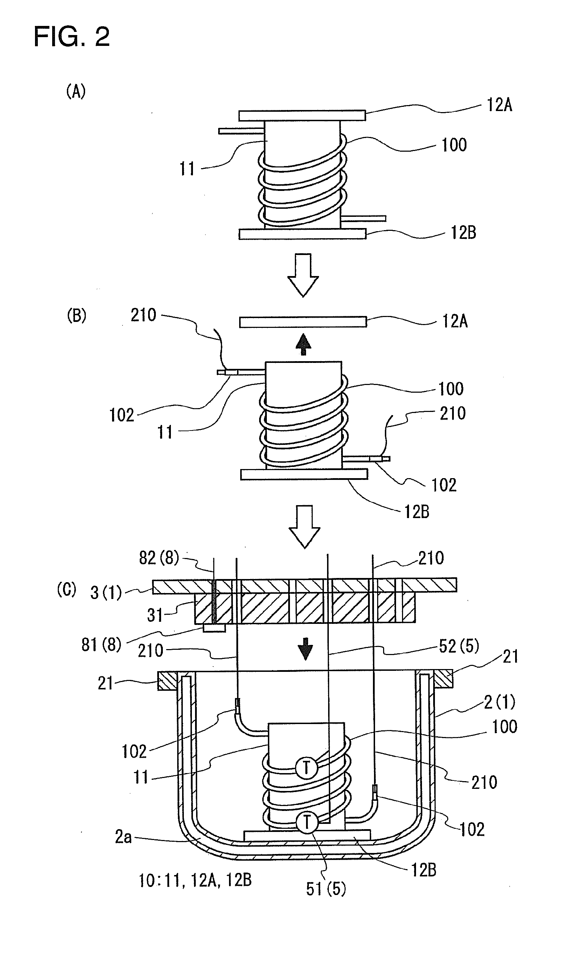

In the present embodiment, as illustrated in FIGS. 1 and 2(C), the cable core 100 is wound around a drum 10 and disposed in a cryostat 1. Then, the cable core 100 may be made compact, and the cryostat 1 that stores the cable core 100 may also be made compact.

As illustrated in FIG. 2, the drum 10 includes a cylindrical winding drum 11, and annular flange portions 12A, 12B which protrude respectively from peripheral edges of opposite ends of the winding drum 11 in a radially outward direction of the winding drum 11.

Since the drum 10 is immersed in the coolant, the drum 10 may be made of a high strength metallic material that is resistant to the coolant and have strength that allows the cable core 100 to be wound therearound, such as, for example, a high carbon steel or a stainless steel. A metallic material generally shrinks when it is cooled. The iron-based alloys have a thermal shrinkage ratio which is smaller than that of the copper or copper alloy used for the former 101 of the cable core 100, and when cooled together with the copper or the copper alloy, the thermal shrinkage amount of the iron-based alloys may be smaller than that of the copper or copper alloy. Accordingly, in a case where the drum 10 (in particular, the winding drum 11) is made of the iron-based alloys described above, the cable 100 may be prevented from being damaged when the winding drum 11 and the cable core 100 are thermally shrunk by, for example, allowing the drum 10 to be cooled earlier than the cable core 100.

Alternatively, at least the winding drum 11 may be made of a material having a thermal shrinkage ratio higher than that of a constituent material of a main component that shares tension acting on the cable core 100, i.e. a tensile strength member, among the components of the cable core 100. The tensile strength member may be, for example, the former 101 which is made of a normal conducting metallic material such as, for example, copper or a copper alloy, as described above. Accordingly, the winding drum 11 of the drum 10 may be typically made of a material that has a thermal shrinkage ratio sufficiently higher than that of copper or a copper alloy which is the constituent material of the former 101, such as, for example, aluminum, an aluminum alloy, magnesium, or a magnesium alloy.

In addition to the advantage of having a thermal shrinkage ratio higher than that of the constituent material of the former 101 (*e.g*., copper), aluminum, magnesium, and alloys thereof have advantages in that (1) since they are light in weight, the weight of the testing object can be reduced, and (2) since they are nonmagnetic materials, an electromagnetic field formed by the cable core 100 is hardly disturbed, for example, even when a test in which an electrifying current value is large is performed. Besides, since aluminum and alloys thereof are excellent in corrosion resistance and magnesium and alloys thereof are most excellent in specific strength and specific rigidity among structural metals, they can be used for the drum with improved strength.

The winding drum 11 and the flange portions 12A, 12B are typically made of the same material. In a form in which one flange portion 12A is attachable/detachable as described below, the flange portion 12A may be made of a material which is different from that of the winding drum 11.

The winding drum 11 has an outer peripheral contour of a circular shape in cross section as described above. Specifically, the winding drum may be formed, for example, by using a cylindrical member, arranging a plurality of arc pieces with a fan-shape cross section on the circumference, or arranging a plurality of rods on the circumference. In the case where the winding drum 11 is the cylindrical member, it is easy to wind the cable core 100 when the winding drum 11 is made in a form in which aligning grooves or aligning partitions for aligning turns of the cable core 100 are provided on the outer periphery surface thereof. When the cylindrical member is hollow, the winding drum 11 is light in weight. Further, the inner peripheral space of the winding drum 11 may be filled with the coolant after the winding drum 11 is stored in the cryostat 1 so that the cable core 100 can be efficiently cooled. This may also be applied to the case where the winding drum 11 is configured using the plurality of arc pieces or rods. In addition, in the case where the winding drum 11 is constituted using the plurality of rods, when the rods are capable of being replaced at the radial center side before cooling the core, or a movement mechanism that slides the rods with respect to the flange portions are provided to be capable of sliding the rods at the radial center side, the diameter of the winding drum 11 itself may be reduced according to the reduction of the diameter of the core 100. The outer diameter of the winding drum 11 (= the inner diameter of the flange portions 12A and 12B + the thickness of the winding drum 11 x 2) may be selected depending on the allowable bending radius of the core 100. Moreover, the axial length of the winding drum 11 may be selected depending on the length of the core 100.

Both the flange portions 12A, 12B are typically annular bodies. When the outer diameter of the flange portions 12A, 12B is larger than the outer diameter of the turns of the cable core 100, the end surfaces of the turns can be held by the flange portions 12A, 12B, which makes it easy to prevent the collapse of winding.

At least one of the flange portions 12A, 12B may be configured in a form in which a plurality of arc pieces are combined to be arranged in an annular shape, or in a form in which a notch is provided in a portion of an annular body. In the former case, the flange portion may not be provided at a portion in the circumferential direction of the winding drum 11. The ends of the cable core 100 or the lead electrodes 210 may be drawn out from a gap portion where the flange portion does not exist or from the notch portion described above.

The flange portions 12A, 12B are typically integrally held on the winding drum 11. Besides, for example, as illustrated in FIGS. 1, 2(B), and 2(C), one flange portion 12A may be configured in a form which is attachable to/detachable from the winding drum 11. The attachment/detachment of the winding drum 11 and the flange portion may be easily performed, for example, by screw-fixing of the one end of the winding drum 11 to the flange portion 12A. More specifically, the winding drum 11 and the flange portion 12A may be attached to/detached from each other as follows. In the case where the winding drum 11 is constituted using the cylindrical member or arc pieces, the winding drum 11 and the flange portion 12A may be attached to/detached from each other by positioning the ends of these members in relation to the inner peripheral surface of the flange portion 12A and fastening/releasing a bolt therethrough. Or, in the case where the winding drum 11 is constituted using the rods, the winding drum 11 and the flange portion 12A may be attached to/detached from each other by engaging/disengaging male screws formed on the front ends of the rods with/from the female screws formed on the flange portion 12A. When the winding drum 11 and the flange portion are attachable/detachable in relation to each other as described above, the testing object may be stored in the cryostat 1 in a state where the one flange portion 12A is removed. When the one flange portion 12A does not exist, the lead electrode 210 does not come into contact with the flange portion 12A so that it is not necessary to increase the length of the lead electrode 210 to make a detour in order to avoid the contact with the flange portion 12A.

When the one flange portion 12A is removed, the winding of the cable core 100 may collapse since the holding state by the flange portions 12A and 12B is released. As a measure to this problem, for example, as illustrated in FIGS. 2(B) and 2(C), a shape holding member 13 may be mounted on the other flange portion 12B to prevent the collapse of winding on the outer periphery of the core 100 wound around the winding drum 11. The shape holding member 13 may be formed by arranging a plurality of segmented members such as, for example, rod-shaped bodies, strip-shaped bodies, or arc pieces, in an annular shape to surround the outer periphery of the wound core 100 at appropriate intervals therebetween. A mounting part for the shape holding member 13 is provided on the other flange portion 12B. For example, holes or slots, into which the segmented members are inserted, may be provided on the flange portion 12B and flange parts, which are fixedly fitted in the holes or slots when the flange parts are inserted into the holes or slots, may be provided on the segmented members. The flange parts and the flange portion 12B may be fixed to each other by, for example, bolts. Since the shape holding member 13 is also immersed in the coolant, the shape holding member 13 may be made of a material which is excellent in resistance to the temperature of the coolant, for example, a high strength material such as a stainless steel. In addition, the shape holding member 13 is disposed more outside than the outer diameter of the core 100 prior to cooling so that the shape holding member 13 would not press the core 100 when the shape holding member 13 thermally shrinks.

The cable core 100 is typically wound around the drum 10 in a single layer, but may be wound in multilayers. When the cable core 100 is wound in multilayers, the drum 10 is provided with a winding drum member (not illustrated) instead of the shape holding member 13 described above. The winding drum member is mounted at least on the flange portion 12B and serves as a winding drum from the second layer. When the winding drum member is configured using a plurality of segmented members like the shape holding member 13 described above, it may be easily attached. The winding drum member may be formed in an annular shape to surround, for example, the outer periphery of the wound underlayer core 100 and to be disposed out of the outer diameter of the underlayer core 100 prior to cooling. In the present invention, the winding drum member may also be made of the same material as the winding drum 11 described above.

### [Cryostat]

The cryostat 1 includes a bottomed cylindrical main body part 2 that is opened at one end side, and a cover part 3 that covers the opening of the main body part 2 (FIG. 1). The cryostat 1 is further provided with, for example, a temperature measurement means 5, a pressure measurement means 6, a gas phase pressurizing means 7, a liquid-level measurement means 8, and a stirring means 9. The cryostat 1 is not provided with a cooling system that performs circulative cooling of the liquid coolant 2L within the cryostat 1.

### (Main Body Part)

The main body part 2 has a vacuum thermal insulation structure that is provided with a vacuum thermal insulation layer 2a formed according to the shape of the main body part 2. The vacuum thermal insulation layer 2a is not necessarily a single layer, but may be multilayers. Besides, double spaces may be formed according to the shape of the main body part in which the inner layer of the double spaces may be filled with a coolant (which may be either a liquid or a gas) and the outer layer may be used as the vacuum thermal insulation layer 2a.

The main body part 2 is provided with a coolant inlet tube 2P so as to introduce the liquid coolant 2L into the inside of the main body part 2. The coolant inlet tube 2P may be provided with, for example, a proper valve, to be switched between a communication state and a non-communication state. The coolant inlet tube 2P may be provided in the cover part 3 to be described later.

The main body part 2 may be properly made of a high strength material that is excellent in resistance to the temperature of the coolant (*e.g.*, about 77K when the coolant is liquid nitrogen), such as, for example, a stainless steel, and is capable of retaining the heavy self-weight of the testing object such as the cable core 100 wound around the drum 10. According to the present embodiment, the main body part 2 is formed to have a volume that sufficiently stores the testing object (in the present embodiment, a volume that is capable of storing the drum 10 wound with the cable core 100 and allowing the cable core 100 wound around the drum 10 to be entirely immersed in the liquid coolant 2L). In addition, a mounting part 21 is provided at the opening side of the main body part 2 so as to mount the cover part 3.

### (Cover Part)

The cover part 3 is a member for sealing the liquid coolant 2L *(e.g.,* liquid nitrogen, liquid oxygen, liquid air, or liquid helium) within the cryostat 1, and the gas phase 2A formed above the liquid coolant 2L. The cover part 3 may also be formed as a vacuum thermal insulation structure, which may become a complicated structure when the lead electrodes 210 or other members such as signal lines 52, 82 to be described later are drawn out. Thus, in the present embodiment, the cover part 3 is formed using a solid body (*e.g*., a stainless steel plate), and a plurality of through holes are provided therethrough so as to draw out the lead electrodes 210 or the signal lines 52, 82.

When the cover part 3 is not formed in a vacuum thermal insulation structure as in the present embodiment, heat penetration through the cover part 3 increases. Thus, in the present embodiment, a thermal insulator 31 formed of a foamed resin such as, for example, urethane, is provided on the bottom surface of the cover part 3 (the main body part 2 side) to reduce the heat penetration through the cover part 3. The outer diameter of the thermal insulator 31 substantially conforms to the inner diameter of the opening of the main body part 2 so that when the cover part 3 is mounted on the main body part 2, the thermal insulator 31 is fitted in the inside of the main body part 2.

As a technique for suppressing the heat penetration through the cover part 3, for example, a configuration that cools the cover part 3 may be adopted. For example, a coolant channel may be formed on the top surface of the cover part 3 so as to cool the cover part 3. Additionally, a coolant channel may be formed within the cover part 3 so as to cool the cover part 3. The coolant flowing through the coolant channel may be either a gas or a liquid. In addition, the coolant is provided independent from the liquid coolant 2L within the cryostat 1. For example, a tank that stores the coolant may be separately provided so that the coolant may be fed to the coolant channel from the tank. In addition, in a case where the dual spaces may be formed in the main body part 2 as described above and the inner layer of the dual spaces is configured to be filled with the coolant, a configuration that introduces the coolant evaporated from the inner layer into the coolant channel of the cover part 3 may be adopted.

In addition, the cryostat may be configured such that the cover part is disposed on the bottom of the cryostat. In such a case, the cryostat may be formed when a bell-shaped main body part is put on the cover part.

### (Temperature Measurement Means)

The temperature measurement means 5 includes a resistance thermometer 51 made of such as platinum, and a signal line 52 that transmits measured temperature data to an input interface 41 of the control device 4 to be described later. The resistance thermometer 51 is more desirable than, for example, an optical fiber or a thermocouple in terms of measurement accuracy. In the full-length test of the cable core, an error of 1°C to 2°C in measured temperature may have a great effect on reliability of test results.

The resistance thermometer 51 may be provided at least at each axial end side of the cable core 100 wound around the drum 10 in a coil shape (hereinafter, the cable core 100 is referred to as a "coil body"). In the configuration of the present invention, the liquid coolant 2L is not subjected to a circulative cooling. Thus, for example, even if the liquid coolant 2L is in a condition suitable for the test at one axial end side, it cannot be said that the liquid coolant 2L is in the same condition at the other end side as well. Considering the possibility that the temperature of the liquid coolant 2L may vary depending on a measuring position, a plurality of resistance thermometer 51 may be provided along the axial direction of the coil body per a predetermined number of turns of the coil body.

In addition, as illustrated, the plurality of resistance thermometers 51 may also be arranged side by side on the flange portion 12B of the drum 10 in a direction orthogonal to the axial direction of the drum 10, or the plurality of resistance thermometers 51 may be arranged side by side along the side wall of the main body part of the cryostat 1. When the resistance thermometers 51 are arranged around the cable core 100 which is the testing object, a correct determination may be made as to whether the cable core 100 is in a condition suitable for test. In addition, with this arrangement, the state of heat penetration from the outside of the cryostat 1 can be determined, so that the time limit to the termination of test can be estimated from the state of heat penetration.

### (Pressure Measurement Means)

The pressure measurement means 6 includes a pressure gauge 61, a communicating tube 62 that communicates with the gas phase 2A, and a signal line 63 through which pressure data measured by the pressure gauge 61 is transmitted to the input interface 41 of the control device 4, and measures the pressure of the gas phase 2A within the cryostat 1. The pressure gauge 61 is configured to output the measured pressure data as an electrical signal. In addition, the signal line 63 is connected to the input interface 41 of the control device 4.

### (Gas Phase Pressurizing Means)

The gas phase pressurizing means 7 introduces the cooling gas into the gas phase 2A within the cryostat 1 to pressurize the gas phase 2A to a pressure higher than atmospheric pressure. For example, the gas phase pressurizing means 7 includes a tank 71, a gas pipe 72 extending from the tank 71 through the cover part 3 of the cryostat 1 and opened to the gas phase 2A, and a pump 73 that feeds the cooling gas from the tank 71 to the gas pipe 72. The pump 73 is connected to a command means 43 of the control device 4 via a signal line 74. The fed cooling gas may be cooled to a temperature close to the temperature of the liquid coolant 2L within the cryostat 1. In particular, the cooling gas may be a gas coolant which is the same kind as the liquid coolant 2L. For example, when the liquid coolant 2L is liquid nitrogen, nitrogen gas is used as the cooling gas fed by the gas phase pressurizing means 7.

### (Liquid-level Measurement Means)

The liquid-level measurement means 8 includes a liquid-level gauge 81 that measures the height of the liquid-level of the liquid coolant 2L, and a signal line 82 through which the measured liquid-level height is transmitted to the input interface 41 of the control device 4. For example, a liquid-level gauge using a laser may be properly used as the liquid-level gauge 81.

### (Stirring Means)

The stirring means 9 may be configured using a rotary body such as, for example, a fin. When the stirring means 9 is provided, the liquid coolant 2L filled in the main body part 2 may be stirred so that a temperature difference of the liquid coolant 2L depending on a position can be reduced.

### [Control Device]

The control device 4 may include, for example, an input interface 41 to which information from the temperature measurement means 5, the pressure measurement means 6, and the liquid-level measurement means 8 is input, a determination means 42 that determines whether the cable core 100 is in a condition suitable for test based on the input information, and a command means 43 that issues a command for operating the gas phase pressurizing means 7. In addition, the control device 4 may include a storage means 44 that stores data such as, for example, a saturated vapor pressure curve of the liquid coolant 2L, and a display means 45 that displays a determination result of the determination means 42. The control device 4 including the components described above mainly performs the following two roles.

The first role of the control device 4 is to control the pump 73 of the gas phase pressurizing means 7 through the command means 43 so as to introduce the cooling gas into the gas phase 2A, thereby placing the gas phase 2A in a pressurized state at a pressure higher than the atmospheric pressure. The introduction of the cooling gas may be performed after considering, using the determination means 42, the temperature data of the liquid coolant 2L which was detected by the temperature measurement means 5, the pressure data of the gas phase 2A which was detected by the pressure measurement means 6, and the liquid-level height of the liquid coolant 2L which was detected by the liquid-level measurement means 8. In addition, the command means 43 may control the gas phase pressurizing means 7 according to a predetermined schedule.

The second role of the control device 4 is to determine whether the current test condition is suitable by the determination means 42 with reference to the temperature data and the pressure data, and to display the determination results on the display means 45. In the determination, the determination means 42 may determine whether the temperature of the liquid coolant 2L which is measured by each resistance thermometer becomes equal to or higher than the boiling point with respect to the current pressure of the gas phase 2A with reference to the saturated vapor pressure curve of the liquid coolant 2L stored in the storage means 44. In addition to the determination as to whether the current test condition is suitable, the determination means 42 may estimate a time limit for which the test can be continued. In such a case, as described below, the measurement results of the liquid-level measurement means 8 may be used in addition to the temperature data and the pressure data.

### [Test Method]

Descriptions will be made on a sequence of performing a test for examining electrical characteristics of the above-described cable core 100 over the entire length of the cable core 100. First, as illustrated in FIG. 2(A), the cable core 100 is wound around the drum 10. The winding of the cable core 100 around the drum 10 may be performed in a state where the axis of the drum 10 is disposed parallel to a horizontal plane, unlike the state illustrated in FIG. 2(A). At that time, when the core 100 is wound while the drum 10 is rotated by a proper rotation mechanism, the self-weights applied to respective turns of the cable core 100 are uniformized at the time of winding. A manufactured cable core 100 may be sequentially wound by the drum 10. When the cable core 100 is wound in multilayers, the winding drum member described above may be mounted on each layer. In addition, when the attachable/detachable flange portion 12A is left attached while the cable core 100 is wound around the drum 10, it is easy to wind the cable core 100 around the drum 10.

As illustrated in FIG. 2(B), the lead electrodes 210 are mounted on the exposed superconducting layer 210 at the ends of the cable core 100, respectively, and the resistance thermometers 51 are mounted at proper positions on the cable core 100, the drum 10, and the inner peripheral surface of the main body part 2 (FIG. 1). At this time, when the flange portion 12A of the drum 10 is left removed, it is easy to draw out the ends of the cable core 100 and to mount the lead electrodes 210 on the ends of the cable core 100, respectively. In addition, in order to prevent the winding of the cable core 100 from collapsing when the flange portion 12A is removed, the shape holding member 13 may be disposed on the outer periphery of the cable core 100 and fixed to the other flange portion 12B. Mounting of the lead electrodes 210 and the resistance thermometers 51 may be performed after the cable core 100 is stored in the cryostat 1.

As illustrated in FIG. 2(C), the cable core 100 wound around the drum 10 is stored in the cryostat 1. At this time, the cable core 100 may be stored in the vertical-type storage in which the axis of the drum 10 is parallel to the axis of the main body part 2 of the cryostat 1 (the axis of the cryostat 1 in the depth direction). With the vertical-type storage, the main body part 2 of the cryostat 1 may have a size in which the diameter of the bottom portion of the main body part 2 is slightly larger than the diameter of the flange portion 12B. Thus, the installation area of the cryostat 1 may be reduced. It is also possible to avoid excessive tension acting on the cable core 100. Whereas, in the horizontal-type storage in which the axis of the drum 10 is parallel to the bottom of the main body part 2 of the cryostat 1, excessive tension acts on a portion positioned upward in the vertical direction in each turn of the core 100 wound around the winding drum 11 and thus, the superconducting layer 102 of the cable core 100 may be damaged.

The cover part 3 is mounted on the main body part 2, the lead electrode 210 and the signal lines 52, 82, for example, are properly drawn out from the cover part 3, and the areas where the lead electrode 210, and the signal lines 52, 82 are drawn out are sealed using, for example, a bushing and a hermetic seal. In addition, for example, the communicating tube 62 of the pressure measurement means 6 and the gas pipe 72 of the gas phase pressurizing means 7 are mounted on the cover part 3 and sealed using, for example, a bushing and a hermetic seal. Further, the signal lines of various means 5, 6, 7, 8 are connected to the control device 4 so that the various means 5, 6, 7, 8 can be operated, and the power supply 300 (FIG. 1) is connected to the lead electrodes 210 extending from the superconducting layer 102 so that the superconducting layer 102 can be electrified or charged.

When the main body part 2 is sealed by the cover part 3, as illustrated in FIG. 1, a predetermined amount of liquid coolant 2L *(e.g.,* liquid nitrogen) is filled in the cryostat 1 from the coolant inlet tube 2P of the cryostat 1 so as to place the superconducting layers such as, for example, the superconducting layer 102 provided in the cable core 100, in the superconducting state. When filling the liquid coolant 2L, the liquid-level of the liquid coolant 2L may be positioned at least 5 cm higher than the upper end of the cable core 100. In addition, the distance between the liquid-level of the liquid coolant 2L and the bottoms surface of the cover part 3 may be set to be at least 20 cm. As this distance increases, a temperature gradient is formed in the height direction in the gas phase 2A so that the boiling of the liquid coolant 2L by the heat penetration may be suppressed.

When the filling of a predetermined amount of the liquid coolant 2L is finished, the gas phase pressurizing means 7 is operated by the control device 4 so as to place the gas phase 2A in the pressurized state at a pressure higher than the atmospheric pressure. Then, the boiling point of the liquid coolant 2L increases, and the liquid coolant 2L is hardly vaporized. In addition, the pressurization of the gas phase 2A may be performed while filling the liquid coolant 2L.

Subsequently, the power supply 300 is turned ON to measure the electrical characteristics of the cable core 100 *(e.g.,* a current carrying performance and an electrical insulating performance). At the time of this measurement, the control device 4 monitors whether the cable core 100 is in a condition suitable for measurement with reference to the temperature data of the liquid coolant 2L which is measured by the temperature measurement means 5 and the pressure data of the gas phase 2A which is measured by the pressure measurement means 6. Specifically, the determination means 42 of the control device 4 acquires the temperature data and the pressure data through the input interface 41, and compares these data with the saturated vapor pressure curve of the liquid coolant 2L stored in the storage means 44. Then, the determination means 42 determines whether or not the temperature measured by the temperature measurement means 5 at each measured location becomes equal to or higher than the boiling point corresponding to the current pressure of the gas phase 2A, and displays the determination results on the display means 45. When the measured temperature becomes equal to or higher than the boiling point, the determination means 42 may display an alarm on the display means 45 and cause the test to be automatically stopped.

In the configuration of the present embodiment, during all the time the measurement is performed, the gas phase pressurizing means 7 is controlled by the control device 4 to adjust the introduced amount of the cooling gas fed from the tank 71 to the gas phase 2A, and to finely adjust the pressurized state of the gas phase 2A. In controlling the gas phase pressurizing means 7, the temperature data from the temperature measurement means 5, the pressure data from the pressure measurement means 6, and the liquid-level height data from the liquid-level measurement means 8 are used. The temperature data and the pressure data may be used for determining how much margin is left until the temperature of the liquid coolant 2L around the cable core 100 reaches the boiling point in light of the saturated vapor pressure curve of the liquid coolant 2L. In addition, the liquid-level height data is equal to the data of the evaporation amount of the liquid coolant 2L and serves as an index for determining the amount and rate of the heat penetration. Thus, the liquid-level height data may be used for determining the temperature rise rate of the liquid coolant 2L. As described above, the current state of the liquid coolant 2L may be determined based on the data from various means 5, 6, 8 so as to increase or decrease the introduction amount of the cooling gas or stop the introduction.

In the present embodiment, the time limit in which the test can be continued is estimated using the temperature data, the pressure data, and the liquid-level height data. For example, the current state of the liquid coolant 2L is determined from the temperature data and the pressure data, and the time when the superconducting layer 102 transits from the superconducting state to the normal conducting state is estimated from the trend of temperature rise at each temperature measurement location or the amount and rate of the heat penetration based on the liquid-level height.

### [Effect]

According to the configurations of the embodiments described above, electrical characteristics of a cable core 100 can be tested without using a large scale circulation cooling system. In addition, when the gas phase 2A is pressurized by the gas phase pressurizing means 7 at the time of testing, the time in which electrical characteristics of the cable core 100 can be tested can be lengthened compared to a case where the gas phase 2A is not pressurized. In addition, since, throughout the test, the temperature of the liquid coolant 2L and the pressure of the gas phase 2A are measured so as to monitor whether the test is performed under sound conditions, highly reliable test results can be obtained.

The present invention is not limited to the embodiments described above and may be properly changed without departing from the gist of the present invention. For example, the cable core 100 wound around the drum 10 may be suspended from the cover part 3 *(e.g.,* a wire or a support rod) using a proper member so that the arrangement of the cable core 100 to the cryostat 1 may be terminated simultaneously with mounting the cover part 3 on the main body part 2. In such a case, when the bottom of the drum 10 is in the floated state (non-contact state) from the bottom of the main body part 2, the drum 10 and the cable core 100 wound around the drum 10 can be uniformly cooled. In addition, the inside of the cryostat may be replenished with the liquid coolant while the electrical characteristics of the cable core 100 are measured. The replenishment of the liquid coolant may be performed in a pressurized state.

### Industrial Applicability

The method for testing a cable core for a superconducting cable according to the present invention may be suitably used for a shipping test of a cable core, an intermediate test on the way of manufacturing a superconducting cable, and other examination of characteristics at arbitrary time.

### [Reference Numerals]

1: cryostat
2: main body part
2a: vacuum thermal insulation layer 2L: liquid coolant 2A: gas phase 21: mounting part 2P: coolant inlet tube
3: cover part
31: thermal insulator
4: control device
41: input interface 42: determination means 43: command means
44: storage means 45: display means
5: temperature measurement means
51: resistance thermometer 52: signal line
6: pressure measurement means
61: pressure gauge 62: communicating tube 63: signal line
7: gas phase pressurizing means
71: tank 72: gas pipe 73: pump 74: signal line
8 liquid-level measurement means
81: liquid-level gauge 82 signal line
9: stirring means
10: drum
11: winding drum 12A, 12B: flange portion 13: shape holding member 100: cable core
101: former 102: superconducting layer 103: electrical insulating layer
104: outer superconducting layer 105: protective layer
210: lead electrode
300: power supply

## Claims

1. A method for testing a cable core for a superconducting cable, the method comprising:
a storing step in which a cable core provided with a superconducting layer is stored in a cryostat which includes a vacuum thermal insulation layer formed on at least a portion thereof;
a filling step in which the cryostat is filled with a liquid coolant; and
a measuring step in which a cooling gas is introduced into a gas phase within the cryostat to place the gas phase in a pressurized state at a pressure higher than atmospheric pressure, the superconducting layer is electrified or charged while the superconducting layer is maintained in a superconducting state by the liquid coolant, and electrical characteristics are measured over an entire length of the cable core,
wherein, in the measuring step, a pressure of the gas phase and a temperature of the liquid coolant within the cryostat are measured without circulative cooling of the liquid coolant within the cryostat, and the electrical characteristics are measured while monitoring whether the liquid coolant is in a state suitable for continuing the testing, based on results of measurement of the pressure and the temperature.

2. The method of claim 1, wherein an introduction amount of the cooling gas is adjusted based on the measured temperature data of the liquid coolant and the measured pressure data of the gas phase.

3. The method of claim 2, wherein the introduction amount of the cooling gas is adjusted considering heat penetration data to the cryostat, in addition to the temperature data and the pressure data.

4. The method of any one of claims 1 to 3, wherein, in the measuring step, the liquid coolant within the cryostat is stirred.

5. The method of any one of claims 1 to 4, wherein the cryostat includes:
a main body part having a bottomed cylindrical shape with an opening at one end side and including a vacuum thermal insulation layer formed according to the shape of the main body part; and
a cover part configured to close the opening,
wherein the cover part is not provided with the vacuum thermal insulation layer, and
a communicating tube of a pressure measurement means that measures the pressure of the gas phase, a signal line of the temperature measurement means that measures the temperature of the liquid coolant, and a gas pipe of a gas phase pressurizing means that introduces a coolant gas into the gas phase penetrate the cover part.

6. The method of claim 5, wherein a thermal insulator is stacked on at least one surface of the cover part.

7. The method of claim 5 or 6, wherein, in the measuring step, the cover part is cooled by a fluid type coolant.

8. The method of any one of claims 1 to 7, wherein, in the storing step, the cable core is stored in the cryostat in a state where the cable core is wound around a drum.

9. The method of any one of claims 5 to 7, wherein, in the storing step, the cable core is stored in the cryostat together with a drum in a state where the cable core is wound around the drum and suspended from the cover part.

10. The method of claim 9, wherein the drum suspended from the cover part is not in contact with a bottom of the cryostat.

11. The method of any one of claims 8 to 10, wherein, in the storing step, the cable core is stored in the cryostat such that an axis of the drum is parallel to an axis of the cryostat in a depth direction.

12. The method of claim 11, wherein the drum includes a winding drum around which the cable core is wound, and flange portions which are provided on both ends of the winding drum, respectively, at least one flange portion being attachable/detachable with respected to the winding drum, and
in the storing step, the cable core is stored in the cryostat in a state where the one flange portion is removed.

13. A cryostat including a vacuum thermal insulation layer on at least a portion of the cryostat so as to maintain a liquid coolant therein, the cryostat comprising:
a temperature measurement means that measures a temperature of the liquid coolant within the cryostat;
a pressure measurement means that measures a pressure of a gas phase within the cryostat; and
a gas phase pressurizing means that introduces a cooling gas into the gas phase, wherein, when electrical characteristics are measured over an entire length of a cable core provided with a superconducting layer, the cable core and the liquid coolant are stored in the cryostat.

14. The cryostat of claim 13, further comprising:
a main body part having a bottomed cylindrical shape with an opening at one end side and including a vacuum thermal insulation layer formed according to the shape; and
a cover part configured to close the opening,
wherein the cover part is not provided with the vacuum thermal insulation layer, and
a signal line of the temperature measurement means, a communicating tube of the pressure measurement means, and a gas pipe of the gas phase measurement means penetrate the cover part.

15. The cryostat of claim 14, further comprising:
a liquid-level measurement means that measures a height of a liquid-level of the liquid coolant.

16. The cryostat of any one of claims 13 to 15, further comprising:
a stirring means that stirs the liquid coolant.
